# EUROPEAN PATENT SPECIFICATION

(11) **EP 4 500 108 B1**
(45) Date of publication and mention of the grant of the patent: **19.08.2026**
(21) Application number: 23781667.3
(22) Date of filing: 28.03.2023
(51) Int. Cl.: G01L 1/14, G01B 7/16, A61B 90/00

(54) **MICROSCALE FLEXIBLE STRAIN SENSOR**
FLEXIBLER DEHNUNGSSENSOR IM MIKROMASSSTAB
CAPTEUR DE CONTRAINTE FLEXIBLE À L'ÉCHELLE MICROSCOPIQUE

(30) Priority: 29.03.2022 US 202263324839 P
(43) Date of publication of application: 05.02.2025
(73) Proprietor: CARNEGIE MELLON UNIVERSITY, Pittsburgh, Pennsylvania 15213 (US)
(72) Inventor: REDDY, Jay, Pittsburgh, Pennsylvania 15213 (US)
(74) Representative: Forresters IP LLP
(86) International application number: PCT/US2023/016516
(87) International publication number: WO 2023/192238

(56) References cited:
- WO-A1-2022/023482
- CN-A- 105 021 120
- US-A1- 2005 167 702
- US-A1- 2008 179 404
- US-A1- 2009 158 856
- R ZEISER ET AL: "Capacitive strain gauges on flexible polymer substrates for wireless, intelligent systems", JOURNAL OF SENSORS AND SENSOR SYSTEMS, 10 April 2014 (2014-04-10), pages 77 - 86, XP055118856, Retrieved from the Internet <URL:http://www.j-sens-sens-syst.net/3/77/2014/jsss-3-77-2014.pdf> [retrieved on 20140520], DOI: 10.5194/jsss-3-77-2014
- LI ET AL: "Interdigital capacitive strain gauges fabricated by direct-write thermal spray and ultrafast laser micromachining", SENSORS AND ACTUATORS A: PHYSICAL, ELSEVIER BV, NL, vol. 133, no. 1, 20 December 2006 (2006-12-20), pages 1 - 8, XP005809088, ISSN: 0924-4247, DOI: 10.1016/J.SNA.2006.04.008

## Description

### Related Applications

This application claims the benefit of U.S. Provisional Patent Application No. 63/324,839, filed March 29, 2022.

### Background

Traditional resistive strain gauges measure elongation via changes in resistivity of a metal under strain. However, such sensors are not feasible to detect large amounts of elongation (i.e., *ε* > 0.1), as they are inherently limited by the low stretchability of the constituent metal traces. Recently, interdigitated electrode array (IDE) capacitive strain gauges have been introduced that measure strain via the changing capacitance of interdigitated electrodes as they are moved closer together or further apart.

To be stretchable, these sensors must be implemented using flexible conductive elastomer traces. Due to the molding and printing processes required for these materials, they are not compatible with traditional high-volume MEMS fabrication, and are limited to large feature sizes, requiring large-area sensors. 3D fabrication of out-of-plane wavey substrates has been demonstrated to increase the stretchability of IDE capacitive strain sensors implemented using metal traces, but this also increases the fabrication complexity and thickness of the devices.

In the prior art, R. Zeiser et al., "Capacitive strain gauges on flexible polymer substrates for wireless, intelligent systems", Journal of Sensors and Sensor Systems, 10 April 2014, pages 77-86, describes a microfabricated device comprising a plurality of interdigitated fingers, the fingers being moveable relative to one another along a longitudinal axis of the device.

### Summary

Described herein is a novel design of a microfabricated thin-film strain sensor and a method of fabricating the sensor. The sensor uses an interdigitated electrode array supported on a flexible substrate with in-plane trace routing to increase the device stretchability along the axis of elongation, with the fabrication accomplished using high-volume MEMS manufacturing techniques.

### Brief Description of the Drawings

By way of example, a specific exemplary embodiment of the disclosed system and method will now be described, with reference to the accompanying drawings, in which:
**FIG. 1A** is a schematic representation of a sensor in a neutral position; **FIG. 1B** is a schematic representation of the sensor in an elongated position.
**FIG. 2** shows the design of a large-scale sensor fabricated in accordance with embodiments disclosed herein.
**FIG. 3** shows steps (a-h) in one possible manufacturing process of the sensor.

### Detailed Description

The IDE capacitive strain sensor is implemented via an n-finger IDE characterized by the finger width *w*, inter-finger gap *g*, finger height t, and finger length *L*. The number of fingers, finger width, inter-finger gap, finger height and finger length may be customized for different applications based on the sensitivity and area requirements of the sensor, as well as the fabrication resolution. There are trade-offs for selecting various parameters for the device. For example, increasing the number of fingers, the width of the fingers and the length of the fingers will increase the sensitivity of the device at the expense of a larger surface area. Smaller finger width and small gap sizes are desirable because of the reduced surface area of the device but are more expensive to microfabricate due to the need for finer manufacturing resolution and tighter tolerances. Thicker fingers also increase the sensitivity but increase the expense and complexity of thin-film fabrication, as well as increasing the device stiffness.

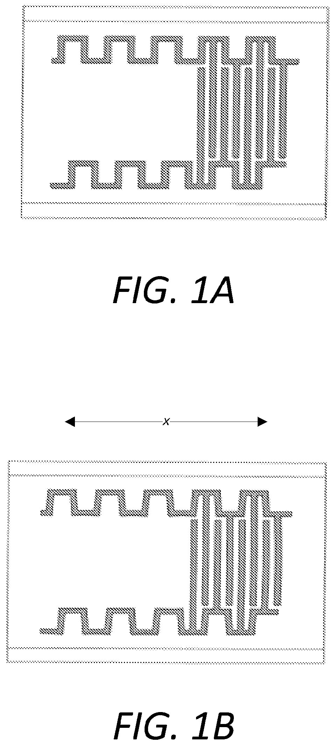

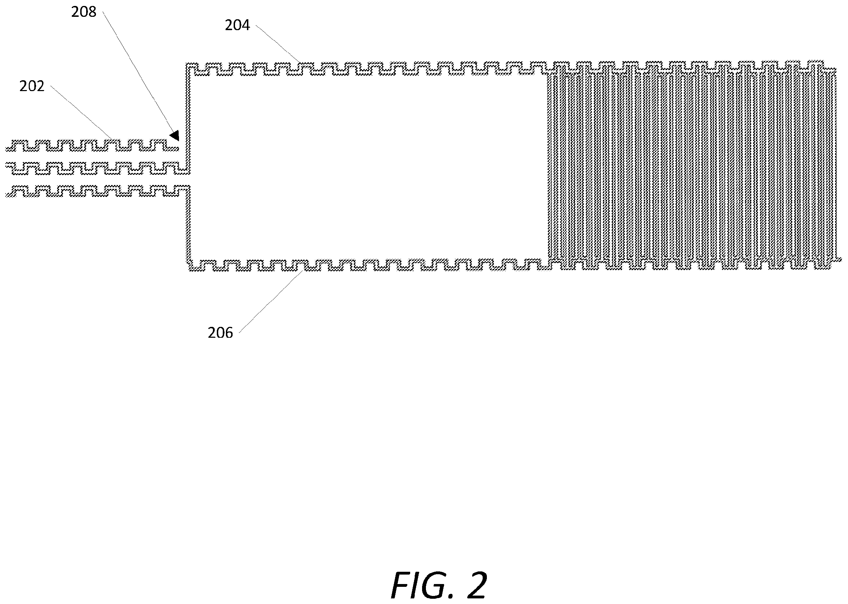

Rather than using straight traces to connect the interdigitated fingers (i.e., ground and sense fingers) of the IDE, the design of embodiments disclosed herein make use of in-plane trace routing to reduce the stiffness of the sensor along the axis of elongation. An exemplary embodiment using a 1st order rectangular routing scheme is shown in **FIG. 1A****,** showing the sensor in the neutral position. **FIG. 1B** shows the sensor of **FIG. 1A** in a position of partial elongation along the longitudinal axis (*X*). The rectangular trace routing reduces strain on the traces when the sensor is elongated. In other embodiments, higher-order self-similar routing and serpentine configurations may also be used. A first trace, shown as reference 204 in **FIG. 2****,** is electrically coupled to a first sub-plurality of the fingers and a second trace, shown as reference 206 in **FIG. 2****,** is electrically-coupled to a second sub-plurality of the fingers, wherein the first and second sub-pluralities are exclusive of each other. In embodiments disclosed herein one trace is a ground trace and the other trace is a sense trace. Preferably, fingers in the first sub-plurality will be disposed between two fingers in the second plurality (except at the ends of the array) and vise-versa, thus forming two sets of interdigitated fingers.

**FIG. 2** shows an exemplary large-scale sensor fabricated in accordance with techniques disclosed herein. In this example, there are n = 100 fingers. The sensor design is highly sensitive to parasitic capacitances. Therefore, the sensor can be employed in a single-ended sensing configuration or in a differential sensing configuration, where a 3rd reference trace 202 is routed in the cable and used in a differential scheme to compensate for the parasitic capacitance of the trace routing in a cable connecting the device to sensing circuitry, which can be considerable and may be highly-dependent on the environment in which the sensor is deployed. The reference trace 202 runs along trace 206 and through the cable. In the differential scheme, the capacitance is measured from the sensor plus the cable, and also from the cable alone, and the capacitance of the sensor can be isolated by taking the difference between the two measured capacitances. In some embodiments, reference trace 202 may be coupled (at location 208, for example) with a purposeful capacitor (i.e., a capacitor of a known capacitance) or other electrical element. The reference trace 202 is constructed in electrically conductive layer 108 and also exhibits self-similar routing, similar to the first and second traces.

Sensors in accordance with embodiments disclosed herein may be attached to various devices, for example, cochlear implants or catheters, to measure device deflection and forces exerted on the device. In various embodiments, multiple sensors can be employed in an array to achieve localized strain measurement. In yet other embodiments, different orientations of the sensors can be used to differentiate strain along multiple axes. For example, sensors may be placed having orthogonal axes of elongation such as to capture elongation in both "X" and "Y" directions. In yet other embodiments, the sensors may be placed at an angle relative to the axis of elongation such as to be able to sense elongation along both axes.

To measure the change in capacitance of the device, the device may be coupled to capacitive sensing circuitry (not shown) which is commercially available as an off-the-shelf item.

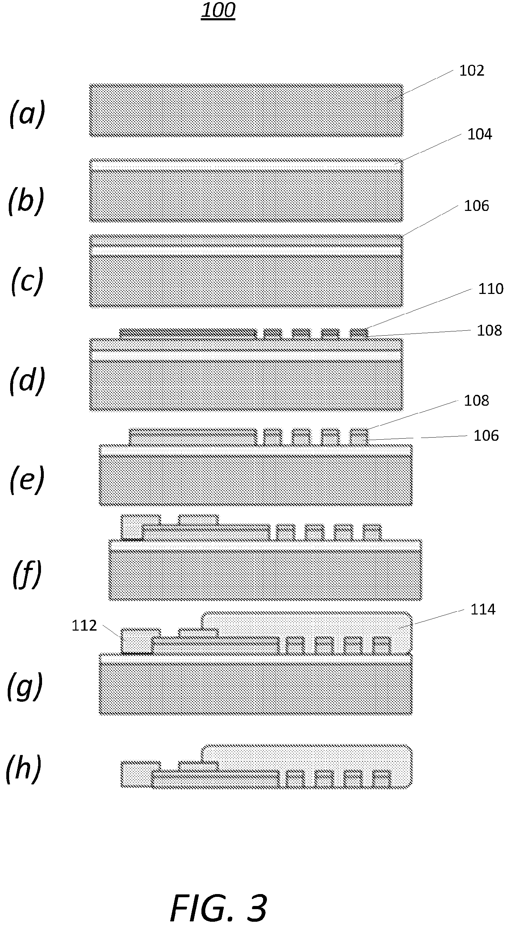

An exemplary microfabrication process 100 to fabricate sensors in accordance with embodiments disclosed herein is shown in **FIG. 3****,** which shows a cross-sectional view of the device in various stages of the fabrication process.

The process begins with a wafer 102 shown step (a). In preferred embodiments, wafer 102 is Si, although any suitable material may be used. In step (b), a release layer 104 is deposited on wafer 102. In one embodiment, release layer 104 may be composed of, for example, Ge, and may be 100 nm in height. As would be realized, any alternative release material known to those of skill in the art could be used. Release layer 104 may be sputtered onto the surface of wafer 102 or deposited via other similar methods (i.e., evaporation, chemical vapor deposition, or spin-coating).

In step (c), a substrate layer 106 is then deposited on release layer 104. In preferred embodiments, substrate layer 106 may be composed of a flexible polymer, for example, Parylene C. However, as would be realized by one of skill in the art, other materials may also be used for substrate layer 106, including, for example, silicone, SU-8, polyamide, SiO₂, SiN, PTFE, PET, PMMA, polyethylene, or similar materials. Substrate layer 106 may preferably be 2 microns in height, although other heights may be used. A thicker substrate layer 106 will add desirable mechanical robustness to the finger traces at the expense of the overall flexibility of the device. In some embodiments, the release layer 104 may be treated to increase adhesion to substrate layer 106 (i.e., using Silane A174 or an appropriate adhesion promotor for the chosen substrate material).

In step (d), an electrically conductive layer 108 is first deposited which will form the electrically conductive portions of the first and second traces 204, 206 and the reference trace 202. The electrically conductive layer 108 may be composed of, in various embodiments, Pt, Au, Cu, or combinations thereof. For example, electrically conductive layer 108 may be a 100 nm layer of Pt or may be a 5nm layer of Pt and a 100nm layer of Au. A hardmask trace 110 is then deposited over the electrically conductive layer 108. In alternate embodiments, the electrically conductive layer 108 may be Al, PEDOT or stacks of other conductive materials.

The hardmask 110 may be, for example, a 40nm layer of Cr, however, as would be realized by one of skill in the art, other materials may also be used, for example, Al, photoresist, SiO₂, etc.

The trace geometry of the interdigitated electrode array is lithographically-defined and a trace stack of the electrically-conductive layer 108 and the hardmask 110 (e.g., Pt/Cr) is evaporated and lifted off. The lift-off process leaves individual stacks forming the fingers of the device and consisting of the substrate material 106 (e.g., Parylene C), the electrically-conductive layer 108 (i.e., Pt or Au) and the hardmask (e.g., Cr), as shown in step (d) in **FIG. 3****.** In such an embodiment, Pt forms the trace material, whereas Cr is a hardmask for patterning the substrate layer 106, which is etched using the Cr hardmask. Etching may be performed using reactive ion etching, wet etching, or similar technique. Alternatively, the fingers may be formed via plasma or chemical etching or laser ablation.

The hardmask 110 is then stripped in step (e), leaving stacks consisting of material from the substrate layer 106 and the electrically-conductive layer 108 forming each of et plurality of fingers. The substrate layer 106 (e.g., Parylene C) only remains under the interdigitated electrode array fingers 108, and any of traces 202, 204, 206.

In step (f) of the process, optional stiffeners 112 may be added to the backend of the device to add strength once the device is released from the wafer 102. In preferred embodiments, stiffeners 112 may be composed of a negative photoresist (e.g., SU-8) and may be applied using lithography. In other embodiments, stiffeners 112 may be composed of Si, SiN, SU-8, Polyimide, Parylene C, or similar materials. In preferred embodiments, stiffeners 112 may be 7 microns in height, but as would be realized by one of skill in the art, any height is acceptable in accordance with the intended use of the device. Stiffeners 112 may be directly printed onto specific regions of the device or deposited and then patterned (i.e., via lithography, wet or dry etching, lift-off, or similar lithographically). In some embodiments, stiffeners 112 may be patterned to expose one or more bondpads to allow electrical connections thereto the first and second traces and the reference trace.

In step (g), the tops of the traces are encapsulated in layer 114. In one embodiment, encapsulation layer 114 is composed of silicone

(polydimethylsiloxane - PDMS) which is spin-coated on the surface to form a substrate after release and insulate the tops of the traces. The encapsulation layer 114 extends between the interdigitated fingers of the sensor. Encapsulation layer 114 may be lithographically patterned and etched or lifted-off to expose the bondpads. The backend bondpads of the sensor may also be protected via Kapton tape or other means during PDMS deposition.

In step (h) the device is released from the silicon wafer 102 by laser-cutting the outline into the encapsulation layer 114 and dissolving the release layer 104. Alternative methods for patterning the encapsulation layer include patterning via wet or dry etching or liftoff. For example, in an embodiment wherein release layer 104 is Ge, a hydrogen peroxide solution may be used to dissolve the Ge.

The sensor may be adhered to other devices (i.e., the devices that are to be sensed, for example, a cochlear implant or catheter) by an adhesive, for example, a silicone adhesive, or the sensor may be incorporate directly into the manufacturing process of the sensed device. Alternatively, any means of coupling the sensor to the sensed device may be used.

The invention is contemplated to include both the devices and the process for manufacturing a multilayered device as described herein using microfabrication techniques. The scope of the invention is defined by the claims which follow.

## Claims

1. A microfabricated device comprising:
a plurality of interdigitated fingers;
wherein each finger is able to move with respect to each other
along a longitudinal axis of the device,
**characterized in that**
each finger forms an independent stack comprising:
a sub-layer (106) composed of a polymer; and
a conductive layer (108) disposed on the sub-layer.

2. The device of claim 1 further comprising:
a first serpentine-shaped electrically-conductive trace (204) coupled to a first sub-plurality of the fingers; and
a second serpentine-shaped electrically-conductive trace (206) coupled to a second sub-plurality of the fingers;
wherein the first and second sub-pluralities of fingers are exclusive of each other.

3. The device of claim 1 wherein the polymer sub-layer is composed of Parylene C, or wherein the conductive layer is composed of platinum, gold or a stack comprising layers of platinum and gold.

4. The device of claim 2 further comprising:
an encapsulation layer (114) covering the plurality of interdigitated fingers and at least partially covering the first and second traces.

5. The device of claim 4 wherein the encapsulation layer extends between the interdigitated fingers, preferably wherein the encapsulation layer of composed of PDMS.

6. The device of claim 1 wherein changing the elongation of the device causes the device to exhibit a change in capacitance, preferably further comprising:
a reference trace (202) allowing a differential measurement of the capacitance of the device.

7. The device of claim 2 further comprising:
one or more stiffener layers (112) covering at least a portion of the first and/or second traces or one or more bondpads electrically coupled to the first and second traces.

8. The device of claim 7 wherein the one or more stiffener layers are etched to expose one or more bondpads electrically coupled to the first and second traces.

9. A method of forming a microfabricated interdigitated electrode array comprising:
depositing a release layer (104) on a wafer (102);
depositing a substrate layer (106) composed of a polymer on the release layer;
depositing a trace layer (108) of an electrically-conductive material on the substrate layer;
depositing a hardmask layer (110) on the trace layer;
patterning the hardmask layer to define a plurality of interdigitated fingers and a plurality of electrical traces;
removing material from the hardmask layer, the trace layer and the substrate layer not forming a part of the plurality of interdigitated fingers or the plurality of electrical traces;
removing the remaining hardmask; and
dissolving the release layer to release the device from the wafer.

10. The method of claim 9 further comprising:
depositing an encapsulation layer (114) prior to the release of the device,
the encapsulation layer covering the plurality of interdigitated fingers and at least partially covering the first and second traces;
wherein the encapsulation layer extends between the interdigitated fingers.

11. The method of claim 10 wherein the encapsulation layer is composed of PDMS.

12. The method of claim 10 further comprising:
depositing one or more stiffeners (112) prior to the release of the device,
the one or more stiffeners covering at least a portion of the first and/or second traces, preferably wherein the one or more stiffeners are etched to expose one or more bondpads electrically coupled to the plurality of traces or wherein the one or more stiffeners are composed of SU-8.

13. The method of claim 9 wherein the plurality of electrical traces comprise:
a first electrically-conductive trace (204) coupled to a first sub-plurality of the fingers; and
a second electrically-conductive trace (206) coupled to a second sub-plurality of the fingers;
wherein the first and second sub-pluralities of fingers are exclusive of each other.

14. The method of claim 13 wherein the plurality of electrical traces further comprise: a reference trace (202).

15. The method of claim 9 wherein the substrate layer is composed of a flexible polymer, preferably wherein the flexible polymer is Parylene C, or wherein the interdigitated fingers and the plurality of traces are formed via a lift-off process, plasma etching, chemical etching or laser ablation.

## Patentansprüche

1. Mikrogefertigte Vorrichtung, umfassend:
eine Vielzahl von kammartig angeordneten Fingern;
wobei jeder Finger relativ zueinander entlang einer Längsachse der Vorrichtung beweglich ist, **dadurch gekennzeichnet, dass**
jeder Finger einen unabhängigen Stapel bildet, umfassend:
eine Substratschicht (106), bestehend aus einem Polymer; und
eine leitfähige Schicht (108), die auf der Substratschicht angeordnet ist.

2. Vorrichtung nach Anspruch 1, ferner umfassend:
eine erste serpentinenförmige elektrisch leitfähige Leiterbahn (204), gekoppelt an eine erste Teilvielzahl der Finger; und
eine zweite serpentinenförmige elektrisch leitfähige Leiterbahn (206), gekoppelt an eine zweite Teilvielzahl der Finger;
wobei die ersten und zweiten Teilvielzahlen von Fingern sich gegenseitig ausschließen.

3. Vorrichtung nach Anspruch 1, wobei die Polymer-Substratschicht aus Parylen C besteht, oder wobei die leitfähige Schicht aus Platin, Gold oder einem Stapel, der Schichten aus Platin und Gold umfasst, besteht.

4. Vorrichtung nach Anspruch 2, ferner umfassend:
eine Verkapselungsschicht (114), die die Vielzahl von kammartig angeordneten Fingern bedeckt und die ersten und zweiten Leiterbahnen mindestens teilweise bedeckt.

5. Vorrichtung nach Anspruch 4, wobei sich die Verkapselungsschicht zwischen den kammartig angeordneten Fingern erstreckt, vorzugsweise wobei die Verkapselungsschicht aus PDMS besteht.

6. Vorrichtung nach Anspruch 1, wobei Ändern der Dehnung der Vorrichtung bewirkt, dass die Vorrichtung eine Änderung der elektrischen Kapazität aufweist, vorzugsweise ferner umfassend:
eine Referenzleiterbahn (202), die eine differenzielle Messung der elektrischen Kapazität der Vorrichtung ermöglicht.

7. Vorrichtung nach Anspruch 2, ferner umfassend:
eine oder mehrere Versteifungsschichten (112), die mindestens einen Teil der ersten und/oder zweiten Leiterbahnen oder ein oder mehrere elektrisch an die ersten und zweiten Leiterbahnen gekoppelte Bondpads abdecken.

8. Vorrichtung nach Anspruch 7, wobei die eine oder mehreren Versteifungsschichten geätzt sind, um ein oder mehrere elektrisch an die ersten und zweiten Leiterbahnen gekoppelte Bondpads freizulegen.

9. Verfahren zur Herstellung einer mikrogefertigten kammartig angeordneten Elektrodenanordnung, umfassend:
Abscheiden einer Trennschicht (104) auf einem Wafer (102);
Abscheiden einer aus einem Polymer bestehenden Substratschicht (106) auf der Trennschicht;
Abscheiden einer Leiterbahnschicht (108) aus einem elektrisch leitfähigen Material auf der Substratschicht;
Abscheiden einer Hartmaskenschicht (110) auf der Leiterbahnschicht;
Strukturieren der Hartmaskenschicht, um eine Vielzahl von kammartig angeordneten Fingern und eine Vielzahl von elektrischen Leiterbahnen zu definieren;
Entfernen von Material von der Hartmaskenschicht, der Leitbahnschicht und der Substratschicht, das keinen Teil der Vielzahl von kammartig angeordneten Fingern oder der Vielzahl von elektrischen Leitbahnen bildet;
Entfernen der verbleibenden Hartmaske; und
Auflösen der Trennschicht, um die Vorrichtung von dem Wafer zu lösen.

10. Verfahren nach Anspruch 9, ferner umfassend:
Abscheiden einer Verkapselungsschicht (114) vor dem Freisetzen der Vorrichtung, wobei die Verkapselungsschicht die Vielzahl von kammartig angeordneten Fingern bedeckt und die ersten und zweiten Leiterbahnen mindestens teilweise bedeckt;
wobei sich die Verkapselungsschicht zwischen den kammartig angeordneten Fingern erstreckt.

11. Verfahren nach Anspruch 10, wobei die Verkapselungsschicht aus PDMS besteht.

12. Verfahren nach Anspruch 10, ferner umfassend:
Abscheiden eines oder mehrerer Versteifungselemente (112) vor dem Freisetzen der Vorrichtung, wobei das eine oder die mehreren Versteifungselemente mindestens einen Abschnitt der ersten und/oder zweiten Leiterbahnen bedecken, vorzugsweise wobei das eine oder die mehreren Versteifungselemente geätzt werden, um ein oder mehrere Bondpads freizulegen, die elektrisch gekoppelt an die Vielzahl von Leiterbahnen sind, oder wobei das eine oder die mehreren Versteifungselemente aus SU-8 bestehen.

13. Verfahren nach Anspruch 9, wobei die Vielzahl von elektrischen Leitbahnen umfasst:
eine erste elektrisch leitfähige Leiterbahn (204), gekoppelt an eine erste Teilvielzahl der Finger; und
eine zweite elektrisch leitfähige Leiterbahn (206), gekoppelt an eine zweite Teilvielzahl der Finger;
wobei die ersten und zweiten Teilvielzahlen von Fingern sich gegenseitig ausschließen.

14. Verfahren nach Anspruch 13, wobei die Vielzahl von elektrischen Leiterbahnen ferner umfasst: eine Referenzleiterbahn (202).

15. Verfahren nach Anspruch 9, wobei die Substratschicht aus einem flexiblen Polymer besteht, vorzugsweise wobei das flexible Polymer Parylen C ist, oder wobei die kammartig angeordneten Finger und die Vielzahl von Leiterbahnen durch einen Lift-off-Prozess, Plasmaätzen, chemisches Ätzen oder Laserablation gebildet werden.

## Revendications

1. Dispositif microfabriqué comprenant :
une pluralité de doigts interdigités ;
dans lequel chaque doigt peut se déplacer l'un par rapport à l'autre le long d'un axe longitudinal du dispositif, **caractérisé en ce que**
chaque doigt forme une pile indépendante comprenant :
une sous-couche (106) composée d'un polymère ; et
une couche conductrice (108) disposée sur la sous-couche.

2. Procédé selon la revendication 1 comprenant en outre :
une première trace électriquement conductrice en forme de serpentin (204) accouplée à une première sous-pluralité de doigts ; et
une seconde trace électriquement conductrice en forme de serpentin (206) accouplée à une seconde sous-pluralité de doigts ;
dans lequel les première et seconde sous-pluralités de doigts sont exclusives l'une de l'autre.

3. Dispositif selon la revendication 1, dans lequel la sous-couche polymère est composée de parylène C, ou dans lequel la couche conductrice est composée de platine, d'or ou d'un empilement comprenant des couches de platine et d'or.

4. Dispositif selon la revendication 2 comprenant en outre :
une couche d'encapsulation (114) recouvrant la pluralité de doigts interdigités et recouvrant au moins partiellement les première et seconde traces.

5. Dispositif selon la revendication 4, dans lequel la couche d'encapsulation s'étend entre les doigts interdigités, de préférence dans lequel la couche d'encapsulation est composée de PDMS.

6. Dispositif selon la revendication 1, dans lequel le changement de l'allongement du dispositif amène le dispositif à présenter un changement de capacité, comprenant de préférence en outre :
une trace de référence (202) permettant une mesure différentielle de la capacité du dispositif.

7. Dispositif selon la revendication 2 comprenant en outre :
une ou plusieurs couches de raidisseur (112) recouvrant au moins une partie des première et/ou seconde traces ou un ou plusieurs plots de connexion couplés électriquement aux première et seconde traces.

8. Dispositif selon la revendication 7, dans lequel la ou les couches de raidisseur sont gravées pour exposer un ou plusieurs plots de connexion couplés électriquement aux première et seconde traces.

9. Procédé de formation d'un réseau d'électrodes interdigitées microfabriqué comprenant :
le dépôt d'une couche de libération (104) sur une plaquette (102) ;
le dépôt d'une couche de substrat (106) composée d'un polymère sur la couche de libération ;
le dépôt d'une couche de trace (108) d'un matériau électroconducteur sur la couche de substrat ;
le dépôt d'une couche de masque dur (110) sur la couche de trace ;
la modélisation de la couche de masque dur pour définir une pluralité de doigts interdigités et une pluralité de traces électriques ;
le retrait de matériau de la couche de masque dur, la couche de trace et la couche de substrat ne faisant pas partie de la pluralité de doigts interdigités ou de la pluralité de traces électriques ;
le retrait du masque dur restant ; et
la dissolution de la couche de libération pour libérer le dispositif de la plaquette.

10. Procédé selon la revendication 9 comprenant en outre :
le dépôt d'une couche d'encapsulation (114) avant la libération du dispositif, la couche d'encapsulation couvrant la pluralité de doigts interdigités et couvrant au moins partiellement les première et seconde traces ;
dans lequel la couche d'encapsulation s'étend entre les doigts interdigités.

11. Procédé selon la revendication 10, dans lequel la couche d'encapsulation est composée de PDMS.

12. Procédé selon la revendication 10 comprenant en outre :
le dépôt d'un ou plusieurs raidisseurs (112) avant la libération du dispositif, le ou les raidisseurs couvrant au moins une partie des première et/ou seconde traces, de préférence dans lequel le ou les raidisseurs sont gravés pour exposer un ou plusieurs plots de connexion couplés électriquement à la pluralité de traces ou dans lequel le ou les raidisseurs sont composés de SU-8.

13. Procédé selon la revendication 9, dans lequel le procédé comprend en outre :
une première trace électriquement conductrice (204) couplée à une première sous-pluralité des doigts ; et
une seconde trace électriquement conductrice (206) couplée à une seconde sous-pluralité des doigts ;
dans lequel les première et seconde sous-pluralités de doigts sont exclusives l'une de l'autre.

14. Procédé selon la revendication 13, dans lequel la pluralité de traces électriques comprend en outre : une trace de référence (202).

15. Procédé selon la revendication 9, dans lequel la couche de substrat est composée d'un polymère souple, de préférence dans lequel le polymère souple est du parylène C, ou dans lequel les doigts interdigités et la pluralité de traces sont formés par l'intermédiaire d'un processus de décollage, de gravure au plasma, de gravure chimique ou d'ablation au laser.
